# EUROPÄISCHE PATENTSCHRIFT

(11) **EP 0 928 511 B1**
(45) Veröffentlichungstag und Bekanntmachung des Hinweises auf die Patenterteilung: **12.12.2001**
(21) Anmeldenummer: 97912025.0
(22) Anmeldetag: 24.09.1997
(51) Int. Cl.: H02H 3/08, G01R 19/25

(54) **SCHALTUNGSANORDNUNG ZUR STROMERFASSUNG EINES STROMLEITERS ZUR ANSTEUERUNG ELEKTRONISCH STEUERBARER AUSLÖSEEINRICHTUNGEN**
CIRCUIT ARRANGEMENT FOR DETECTION OF CURRENT IN AN ELECTRIC CONDUCTOR TO CONTROL ELECTRONICALLY CONTROLLABLE TRIPPING DEVICES
CIRCUIT DE DETECTION DE COURANT DANS UN CONDUCTEUR ELECTRIQUE POUR COMMANDER DES DECLENCHEURS A COMMANDE ELECTRONIQUE

(30) Priorität: 24.09.1996 DE 19641183
(43) Veröffentlichungstag der Anmeldung: 14.07.1999
(73) Patentinhaber: SIEMENS AKTIENGESELLSCHAFT, 80333 München (DE)
(72) Erfinder: HOCHGRAEF, Holger, D-16845 Ganzer (DE); WEGENER, Mario, D-10963 Berlin (DE)
(86) Internationale Anmeldenummer: DE9702216
(87) Internationale Veröffentlichungsnummer: WO9813921

(56) Entgegenhaltungen:
- EP-A- 0 515 712
- EP-A- 0 687 050
- GB-A- 2 008 345

## Beschreibung

Die Erfindung betrifft eine Schaltungsanordnung zur Stromerfassung eines Stromleiters zur Ansteuerung elektronisch steuerbarer Auslöseeinrichtungen mit einer Netzspannungsversorgungseinrichtung, wobei die von der Netzspannungsversorgungseinrichtung erzeugte Betriebsspannung mit einer Referenzspannung verglichen und durch eine bei Überstrom sich bildende Grenzspannung die Auslöseeinrichtung wirksam geschaltet ist. Eine Schaltungsanordnung der eingangs definierten Art ist durch die EP 0 687 050 A2 bekannt. Die Erzeugung der Betriebsspannung und die Stromerfassung erfolgen hier mit analog gesteuerten Schaltmitteln, die für jeden Stromleiter separat zur Verfügung gestellt sind. Es sind in diesem Zusammenhang auch reine Wechselstrom-Messungen mit entsprechenden Auswerteschaltungen bekannt, bei denen für jeden Stromleiter ein eigener sogenannter Bürden-Widerstand vorgesehen ist. Da auch die Bürden-Widerstände toleranzbehaftete Widerstandswerte aufweisen, sind auch die Meßergebnisse bei der Stromerfassung entsprechend ungenau.
Desweiteren ist durch die DE 32 23 687 A1 eine Stromversorgungseinrichtung für Überstromauslöser bekannt, die in Verbindung mit einem Mikroprozessor die Regelung der benötigten Betriebsspannung bewirkt. Allerdings ist hier der Meßkreis zur Stromerfassung von dem Stromkreis zur Erzeugung der Betriebsspannung nicht entkoppelt, so daß gegenseitige Rückwirkungen und damit ungenauere Meßergebnisse erzielt werden.

Die der Erfindung zugrundeliegende Aufgabe besteht darin, eine Schaltungsanordnung zur Stromerfassung von Stromleitern zu definieren, bei der einerseits der Aufwand von teuren Präzisionsbauelementen, insbesondere von Bürden-Widerständen, reduziert ist, bei denen andererseits der Meßvorgang zur Stromerfassung und Auswertung erheblich verbessert ist. Erfindungsgemäß wird dies durch die Merkmale
- 1.1: die Schaltungsanordnung weist eine Mikroprozessoreinrichtung mit einer der Anzahl von Sekundär-Phasenwicklungen entsprechenden Zahl von Meßpotential-Eingängen auf,
- 1.2: jede Sekundär-Phasenwicklung steht mit einer entsprechenden Gleichrichtereinrichtung in Verbindung, deren positive Ausgänge über eine entsprechend nachgeschaltete Diode mit einem Eingang eines Regel-Transistors verbunden sind,
- 1.3: die negativen Ausgänge der entsprechenden Gleichrichtereinrichtungen sind gemeinsam mit einem Ausgang des Regel-Transistors verbunden, der mit einem Versorgungsspannungs-Ausgang der Mikroprozessoreinrichtung und einem Anschluß eines einzigen Bürden -Widerstands elektrisch leitend verbunden ist,
- 1.4: ein weiterer Anschluß des einzigen Bürden-Widerstands bildet gleichzeitig jeweilige erste Eingänge von einer der Anzahl der Sekundär-Phasenwicklungen entsprechenden Zahl von Meß-Transistoren und einem gemeinsamen Netzpotential-Eingang der Mikroprozessoreinrichtung,
- 1.5: jeweilige zweite Eingänge der Meß-Transistoren sind mit den jeweiligen positiven Ausgängen der jeweiligen Gleichrichtereinrichtungen verbunden,
- 1.6: die nachgestalteten Dioden bilden an einem Betriebsspannungs-Ladekondensator eine Betriebsspannung, die mittels einer Spannungsregeleinrichtung einem Versorgungsspannungs-Eingang der Mikroprozessoreinrichtung zugeführt ist,
- 1.7: jeweilige Steuer-Eingänge der Meßtransistoren sind mit einem jeweilig entsprechenden Meßpotential-Eingang derart verbunden, daß zur Stromerfassung nur ein Meß-Transistor schaltbar ist,
erreicht.
Durch die Verwendung der Mikroprozessoreinrichtung, die praktisch zur Regelung der Betriebsspannung beiträgt, ist die Stromerfassung durch einen interruptgesteuerten Hintergrundprozess realisiert. Im Gegensatz zu den bisher analog gesteuerten Meßabtastungen und Spannungsregelungen steuert nunmehr die Mikroprozessoreinrichtung die geregelte Betriebsspannung derart, daß gerade der zur Stromerfassung von der Mikroprozessoreinrichtung ausgewählte Wechselspannungsanteil der einen Sekundär-Phasenwicklung für den Zeitpunkt der Messung gerade nicht zur Erzeugung der Betriebsspannung herangezogen wird. Das Ergebnis ist bei unbelasteter Netzspannung der Sekundär-Phasenwicklung erheblich genauer. Als erfindungswesentlich ist außerdem anzusehen, daß die Schaltungsanordnung als Präzisionsbauelement mit hoher elektrischer Belastbarkeit nur einen einzigen Bürden-Widerstand benötigt, denn die Mikroprozessoreinrichtung benötigt für den intern ablaufenden Meßvorgang nur einen einzigen Meßkanal. Während die interne Steuerung der Mikroprozessoreinrichtung die Wechselspannung jeweils einer Sekundär-Phasenwicklung zur Stromerfassung auswählt, stehen die anderen Wechselspannungen der restlichen Sekundär-Phasenwicklungen der Erzeugung der Betriebsspannung zur Verfügung. Die Stromerfassung und die Erzeugung der Betriebsspannung erfolgt hier im Gegensatz zu den analoggesteuerten Schaltvorgängen in synchronisierter Reihenfolge.

Eine vorteilhafte Ausgestaltung der Erfindung sieht das Merkmal
- 2.1: die Meß-Transistoren sind derart steuerbar, daß die Funktion des Regel-Transistors ersetzt ist,
vor, so daß der zusätzliche Regelkreis entfällt.

Eine weitere vorteilhafte Ausgestaltung der Erfindung sieht das Merkmal
- 3.1: die Meß-Transistoren sind derart steuerbar, daß die Funktion der Spannungsregeleinrichtung ersetzt ist,
vor. Damit ist eine weitere Einsparung von Schaltelementen verbunden, die bei entsprechender Ansteuerung der Meß-Transistoren keine nachteilige Auswirkung auf das Meßergebnis hat.

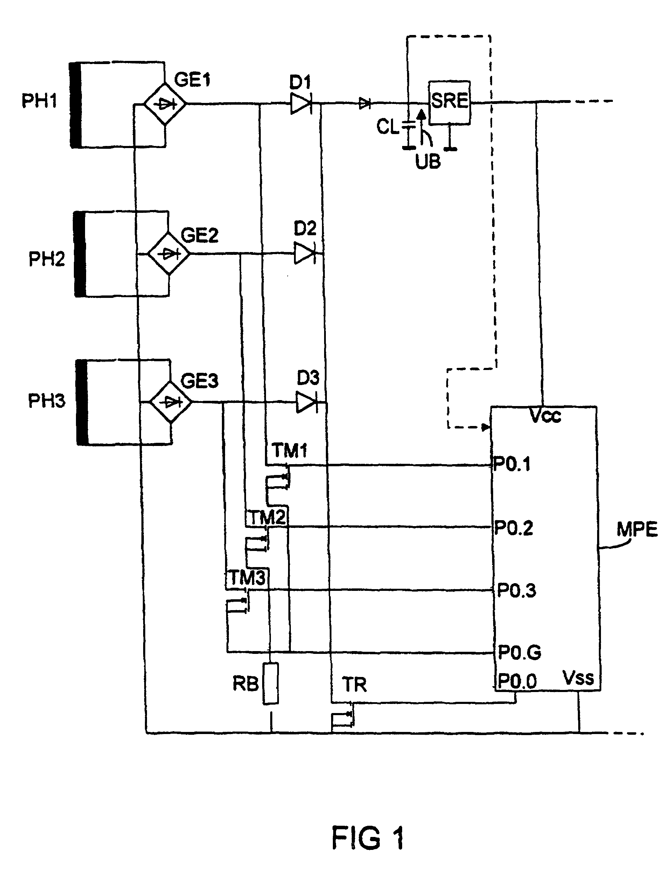

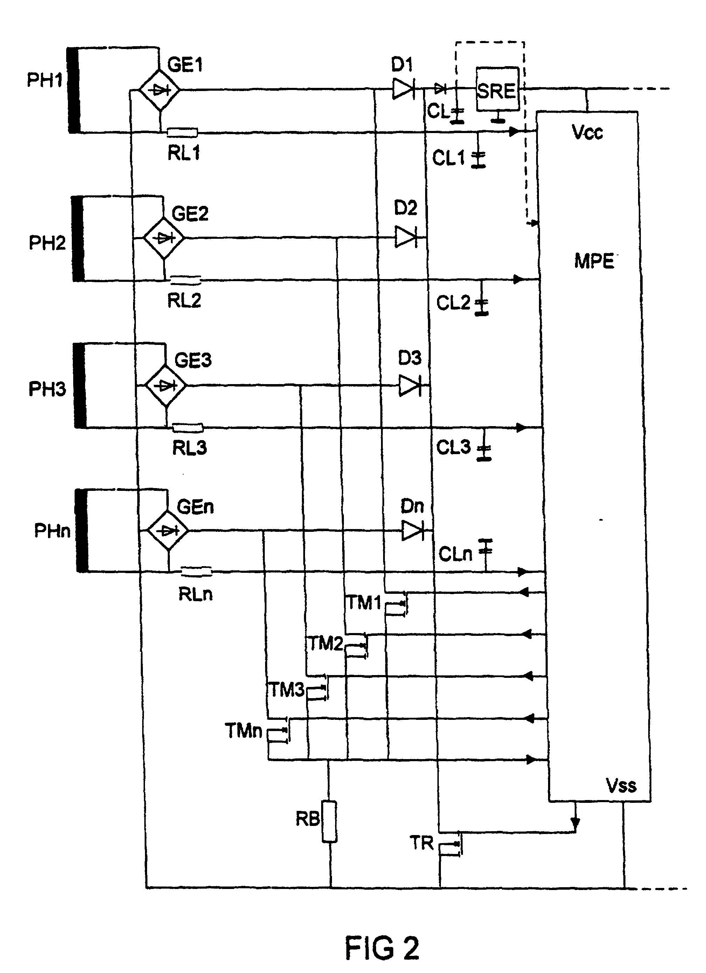

Die Erfindung wird durch zwei in den Figuren 1 und 2 dargestellte Ausführungsbeispiele näher erläutert, wobei in Figur 1 die Stromerfasssung für eine aus drei Sekundär-Phasenwicklungen bestehende Netzspannungsversorgung angegeben ist, während die Figur 2 die Stromerfassung auszugsweise für eine Netzspannungsversorgung zeigt, die aus vier Sekundär-Phasenwicklungen gebildet ist.
Die in Figur 1 dargestellte Netzspannungsversorgung weist die erste, die zweite und die dritte Sekundär-Phasenwicklung PH1, PH2, PH3 auf, deren Wechselspannung durch die jeweils nachgeschaltete erste, zweite und dritte Gleichrichtereinrichtung GE1, GE2, GE3 gleichgerichtet und über die jeweils erste, zweite 0 und dritte Diode D1, D2, D3 an den gemeinsamen Betriebspanungs-Ladekondensator CL geschaltet ist. Außerdem ist diese Verbindung gleichzeitig mit der Ausgangsseite des Regel-Transitors TR verbunden. Die am Betriebsspannungs-Ladekondensator sich bildende Betriebsspannung UB ist mit der Spannungsregeleinrichtung SRE verbunden, deren Ausgang an den Versorgungsspannungs-Eingang Vcc der Mikroprozessoreinrichtung MPE führt. Die positiven Ausgang der jeweiligen erste, zweite und dritten Gleichrichtereinrichtung GE1, GE2, GE3 ist mit dem entsprechenden Ausgang des jeweiligen ersten, zweiten und dritten Meß-Transitors TM1, TM2, TM3 elektrisch leitend verbunden, deren jeweiliger Steuer-Eingang mit dem jeweiligen ersten, zweiten und dritten Meßpotential-Eingang P0.1, P02, P03 der Mikroprozessoreinrichtung MPE in leitender Verbindung steht. Des weiteren ist ersichtlich, daß leitend miteinander verbundene Eingänge eines jeden Meß-Transistors TM1, TM2, TM3 an den gemeinsamen Netzpotential-Eingang P0.G der Mikroprozessoreinrichtung MPE geführt sind. Zwischen dem Netzpotential-Bingang P0.G und dem Versorgungsspannungs-Ausgang Vss der Mikroprozessoreinrichtung MPE ist der für den Meßvorgang benötigte einzige Bürden-Widerstand RB angeordnet. Der Steuer-Eingang des Regel-Transistors TR ist mit dem Meßpotential-Ausgang P0.0 verbunden, während die miteinander verbundenen Eingänge des Regel-Transistors TR ebenfalls an den Versorgungsspannungs-Ausgang Vss der Mikropcozessoreinrichtung MPE geführt sind. Wie bereits erwähnt, dient die Mikroprozessoreinrichtung im wesentliche zur Regelung der Betriebsspannung als Versorgungsspannung, mit der die Stromerfassung der Stromleiter der Netzspannungsversorgung praktisch taktweise errechenbar ist.

Die Figur 2 zeigt ein ähnliches Ausführungsbeispiel für die Schaltungsanordnung zur Stromerfassung eines Stromleiters.

Der wesentliche Unterschied zum Ausführungsbeispiel in der Figur 1 besteht lediglich darin, daß in der hier dargestellten Netzstromversorgung auch der Nulleiter über die SekundärWicklung PHn hinsichtlich eines im Fehlerfall auftretenden Überstromes überwacht ist. Mit den Leitungs-Widerständen RL1, RL2, RL3, n wird im Zusammenhang mit dem entsprechenden ersten, zweiten, dritten und n-ten Ladekondensator CL1, CL2, CL3, n jeweils eine zusätzliche Wechselspannung an nichtbezeichnete Wechselspannungs-Eingänge der Mikroprozessoreinrichtung MPE zur Berechnung der Ströme in den Stromleitern übertragen.

## Patentansprüche

1. Schaltungsanordnung zur Stromerfassung eines Stromleiters zur Ansteuerung elektronisch steuerbarer Auslöseeinrichtungen mit einer Netzspannungsversorgungseinrichtung, wobei die von der Netzspannungsversorgungseinrichtung erzeugte Betriebsspannung (VB) mit einer Referenzspannung verglichen und durch eine bei Überstrom sich bildende Grenzspannung die Auslöseeinrichtung wirksam geschaltet ist,
**gekennzeichnet durch** die Merkmale
1.1 die Schaltungsanordnung weist eine Mikroprozesssoreinrichtung (MPE) mit einer der Anzahl von Sekundär-Phasenwicklungen (PH 1, PH2, PH3, PHn) entsprechenden Zahl von Meßpotential-Eingängen (P0.1, P0.2, P0.3, P0n) auf,
1.2 jede Sekundär-Phasenwicklung (PH1, PH2, PH3, PHn) steht mit einer entsprechenden Gleichrichtereinrichtung (GE1, GE2, GE3, GEn) in Verbindung, deren positive Ausgänge über eine entsprechend nachgeschaltete Diode (D1, D2, D3, Dn) mit einem Eingang eines Regel-Transistors (TR) verbunden sind,
1.3 die negativen Ausgänge der entsprechenden Gleichrichtereinrichtungen (GE1, GE2, GE3, GEn) sind gemeinsam mit einem Ausgang des Regel-Transistors (TR)verbunden, der mit einem Versorgungsspannungs-Ausgang (Vss) der Mikroprozessoreinrichtung (MPE) und einem Anschluß eines einzigen Bürden -Widerstands (RB) elektrisch leitend verbunden ist,
1.4 ein weiterer Anschluß des einzigen Bürden-Widerstands (RB) bildet gleichzeitig jeweilige erste Eingänge von einer der Anzahl der Sekundär-Phasenwicklungen (PH1, PH2, PH3, n) entsprechenden Zahl von Meß-Transistoren (TM1, TM2, TM3, TMn) und einem gemeinsamen Netzpotential-Eingang (P0.G) der Mikroprozessoreinrichtung (MPE),
1.5 jeweilige zweite Eingänge der Meß-Transistoren (TM1, TM2, TM3, TMn) sind mit den jeweiligen positiven Ausgängen der jeweiligen Gleichrichtereinrichtungen (GE1, GE2, GE3, GEn) verbunden,
1.6 die nachgeschalteten Dioden (D1, D2, D3, Dn) bilden an einem Betriebsspannungs-Ladekondensator (CL) eine Betriebsspannung (UB), die mittels einer Spannungsregeleinrichtung (SRE) einem Versorgungsspannungs-Eingang (Vcc) der Mikroprozessoreinrichtung (MPE) zugeführt ist,
1.7 jeweilige Steuer-Eingänge der Meßtransistoren (TM1, TM2, TM3, TMn) sind mit einem jeweilig entsprechenden MeßpotentialEingang (P01, P02, P03, P0n) derart verbunden, daß zur Stromerfassung nur ein Meß-Transistor (TM1, oder TM2, oder TM3, oder TM4) schaltbar ist.

2. Schaltungsanordnung zur Stromerfassung eines Stromleiters nach Patentanspruch 1,
**gekennzeichnet durch** das Merkmal
2.1 die Meß-Transistoren (TM1, TM2, TM3, TMn) sind derart steuerbar, daß die Funktion des Regel-Transistors (TR) ersetzt ist.

3. Schaltungsanordnung zur Stromerfassung eines Stromleiters nach Patentanspruch 1,
**gekennzeichnet durch** das Merkmal
3.1 die Meß-Transistoren (TM1, TM2, TM3, TMn) sind derart steuerbar, daß die Funktion der Spannungsregeleinrichtung (SRE) ersetzt ist.

## Claims

1. Circuit arrangement for current detection in an electrical conductor for actuating electronically controllable initiation devices having a mains voltage supply device, with the operating voltage (VB) which is produced by the mains voltage supply device being compared with a reference voltage, and the initiation device being switched on by means of a limit voltage which is formed in the event of an overcurrent,
**characterized by** the following features:
1.1 the circuit arrangement has a microprocessor device (MPE) with a number of measurement potential inputs (PO.1, PO.2, PO.3, POn) corresponding to the number of secondary phase windings (PH1, PH2, PH3, PHn),
1.2 each secondary phase winding (PH1, PH2, PH3, PHn) is connected to a corresponding rectifier device (GE1, GE2, GE3, GEn), whose positive outputs are connected via a correspondingly downstream diode (D1, D2, D3, Dn) to an input of a control transistor (TR),
1.3 the negative outputs of the corresponding rectifier devices (GE1, GE2, GE3, GEn) are jointly connected to an output of the control transistor (TR), which is electrically conductively connected to a supply voltage output (Vss) of the microprocessor device (MPE), and to a connection of a single burden resistor (RB),
1.4 a further connection of the single burden resistor (RB) at the same time forms respective first inputs of a number of measurement transistors (TM1, TM2, TM3, TMn) corresponding to the number of secondary phase windings (PH1, PH2, PH3, n) (lacuna) to a common mains potential input (PO.G) of the microprocessor device (MPE),
1.5 respective second inputs of the measurement transistors (TM1, TM2, TM3, TMn) are connected to the respective positive outputs of the respective rectifier devices (GE1, GE2, GE3, GEn),
1.6 the downstream diodes (D1, D2, D3, Dn) form an operating voltage (UB) across an operating voltage charge-storage capacitor (CL), which operating voltage (UB) is supplied by means of a voltage regulating device (SRE) to a supply voltage input (Vcc) of the microprocessor device (MPE),
1.7 respective control inputs of the measurement transistors (TM1, TM2, TM3, TMn) are connected to a respectively corresponding measurement potential input (PO1, P02, P03, POn) in such a manner that only one measurement transistor (TM1, or TM2, or TM3, or TM4) can be switched for current detection.

2. Circuit arrangement for current detection in an electrical conductor according to Patent Claim 1,
**characterized by** the following feature:
2.1 the measurement transistors (TM1, TM2, TM3, TMn) can be controlled in such a manner that the function of the control transistor (TR) is replaced.

3. Circuit arrangement for current detection in an electrical conductor according to Patent Claim 1,
**characterized by** the following feature:
3.1 the measurement transistors (TM1, TM2, TM3, TMn) can be controlled in such a manner that the function of the voltage regulating device (SRE) is replaced.

## Revendications

1. Montage pour détecter le courant d'un conducteur de courant en vue de la commande de dispositifs de déclenchement pouvant être commandés de manière électronique, comportant un dispositif d'alimentation en tension du secteur, la tension (UB) de fonctionnement produite par le dispositif d'alimentation en tension du secteur étant comparée à une tension de référence et le dispositif de déclenchement étant branché à l'état actif par une tension limite se formant en cas de surintensité de courant,
**caractérisé par** les dispositions
1.1 le montage comporte un dispositif (MPE) microprocesseur comportant un nombre d'entrées (P0.1, P0.2, P0.3, P0.n) des potentiels de mesure correspondant au nombre d'enroulements (PH1, PH2 , PH3, PHn) de phases secondaires,
1.2 chaque enroulement (PH1, PH2, PH3, PHn) de phases secondaires est en liaison avec un dispositif (GE1, GE2, GE3, GEn) correspondant, dont les sorties positives sont reliées par l'intermédiaire d'une diode (D1, D2, D3, Dn), montée en aval en conséquence à une entrée d'un transistor (TR) de régulation,
1.3 les sorties négatives des dispositifs (GE1, GE2, GE3, GEn) redresseurs correspondants sont reliées conjointement à une sortie du transistor (TR) de régulation, qui est reliée de manière conductrice de l'électricité à une sortie (Vss) de tension d'alimentation du dispositif (MPE) microprocesseur et à une borne d'une unique résistance (RB) de charge, des enroulements (PH1, PH2, PH3, PHn) de phases secondaires et une entrée (P0.G) de potentiel du secteur commune du dispositif (MPE) microprocesseur,
1.5 des deuxièmes entrées respectives des transistors (TM1, TM2, TM3, TMn) de mesure sont reliées aux sorties positives respectives des dispositifs (GE1, GE2, GE3, GEn) redresseurs respectifs,
1.6 les diodes (D1, D2, D3, Dn) en aval forment sur un condensateur (CL) de charge de tension de fonctionnement une tension (UB) de fonctionnement, qui est envoyée au moyen d'un dispositif (SRE) de régulation de tension à une entrée (Vcc) de tension d'alimentation du dispositif (MPE) microprocesseur,
1.7 des entrées de commande respectives des transistors (TM1, TM2, TM3, TMn) de mesure sont reliées à une entrée (P01, P02, P03, P0n) de potentiel de mesure respectivement correspondante de telle manière qu'un seul transistor (TM1, ou TM2, ou TM3, ou TM4) peut être branché pour la détection du courant.

2. Montage pour détecter le courant d'un conducteur de courant suivant la revendication 1,
**caractérisé par** la disposition
2.1 les transistors (TM1, TM2, TM3, TMn) de mesure peuvent être commandés de telle manière que la fonction du transistor (TR) de régulation est remplacée.

3. Montage pour détecter le courant d'un conducteur de courant suivant la revendication 1,
**caractérisé par** la disposition
3.1 les transistors (TM1, TM2, TM3, TMn) de mesure peuvent être commandés de telle manière que la fonction du dispositif (SRE) de régulation de tension soit remplacée.
